# DEMANDE DE BREVET EUROPEEN

(11) **EP 1 111 787 A1**
(43) Date de publication de la demande: **27.06.2001**
(21) Numéro de dépôt: 00410164.8
(22) Date de dépôt: 22.12.2000
(51) Int. Cl.: H03K 17/30

(54) **Générateur analogique d'impulsions de tension**

(30) Priorité: 24.12.1999 FR 9916491
(71) Demandeur: STMicroelectronics S.A., 94250 Gentilly (FR)
(72) Inventeur: Gonthier, Laurent, 37000 Tours (FR); Destouches, Mickael, 37350 Serrière Larcon (FR); Jalade, Jean, 31320 Castanet-Tolosan (FR)
(74) Mandataire: de Beaumont, Michel

(57) **Abrégé**

L'invention concerne un générateur analogique (10') d'impulsions de tension comportant un premier composant (11) à retournement de type diode Shockley pour activer un front montant d'une impulsion sur une borne de sortie (17) et un deuxième composant (12') de type thyristor pour bloquer le premier composant et désactiver l'impulsion.

## Description

La présente invention concerne la commande impulsionnelle (répétitive ou monocoup) d'un ou plusieurs interrupteurs de type MOS ou équivalent. L'invention concerne plus particulièrement la réalisation d'un générateur d'impulsions de tension pour la commande de tels interrupteurs. Par interrupteur MOS ou équivalent, on entend au sens de la présente invention tout interrupteur devant être commandé par un niveau de tension comme, par exemple, les transistors MOS ou les IGBT (transistors bipolaires à grille isolée). L'invention concerne plus particulièrement la commande de tels interrupteurs utilisés dans le domaine de la régulation de puissance pour contrôler le fonctionnement d'équipements industriels et domestiques. Dans un tel domaine, on utilise souvent des composants semiconducteurs de puissance fonctionnant en commutation pour réaliser des commandes dites à contrôle de l'angle à conduction (ou à contrôle de phase) et dans lesquelles un interrupteur de puissance n'est rendu passant que pendant une partie de la durée de chaque alternance ou d'une alternance sur deux de la tension d'alimentation. De tels systèmes sont couramment utilisés dans le domaine de l'éclairage domestique pour réaliser des variateurs de lumière, et dans de nombreuses autres applications pour constituer des variateurs de puissance.

La régulation de puissance par ccmmande d'angle de conduction présente l'inconvénient bien connu de générer, sur le secteur, des harmoniques dues au fait que l'interrupteur (par exemple, un triac) se ferme tandis qu'il existe une tension relativement importante à ses bornes. Les harmoniques provoquent des perturbations électromagnétiques et constituent un problème majeur. Diverses normes ont été développées pour imposer au fabricant d'éviter la génération de telles perturbations. Un moyen simple pour éviter la réinjection d'harmoniques sur le secteur consiste à les filtrer. Néanmoins, l'addition d'un filtre passif à un variateur constitue un handicap sérieux en terme d'encombrement, de poids et de coût. Pour éviter ce filtre, on a envisagé également d'attaquer le problème à la base en maîtrisant la vitesse de variation du courant (di/dt) lors des commutations. Hélas, ni les thyristors, ni les triacs - qui sont des composants idéaux pour fabriquer un variateur en raison de leur robustesse, de leur tenue aux surcharges, de leur facilité de commutation et de leur faible puissance dissipée à l'état passant - ne permettent le contrôle du di/dt.

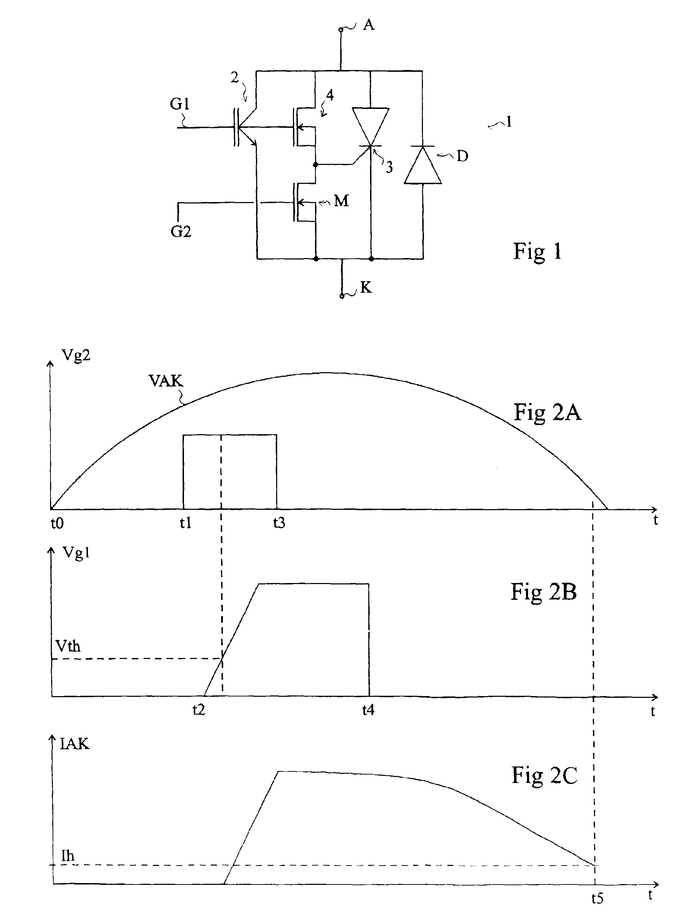

La figure 1 représente un exemple de réalisation d'un interrupteur de puissance à di/dt contrôlé du type auquel s'applique plus particulièrement la présente invention. Un tel circuit se présente, préférentiellement, sous la forme d'un interrupteur monolithique comportant deux bornes A et K de puissance et deux bornes G1 et G2 de commande. Cet interrupteur 1 comprend le montage en parallèle d'un composant 2 de type MOS ou IGBT (transistor bipolaire à grille isolée) et d'un composant 3 de type thyristor, et des moyens pour inhiber le composant de type thyristor pendant une phase de fermeture de l'interrupteur qui est assurée par le composant 2 de type IGBT. Le transistor de puissance de type IGBT 2 et le thyristor de puissance 3 sont connectés en parallèle entre les bornes A et K. L'anode du thyristor 3 et le collecteur de l'IGBT 2 sont connectées à l'anode A. La cathode du thyristor 3 et l'émetteur de l'IGBT sont connectés à la cathode K. Dans le mode de réalisation de la figure 1, une diode D est connectée en antiparallèle sur le thyristor 3 entre les bornes A et K. L'IGBT 2 est relié à une première borne de commande Gl par sa grille. La commande du thyristor 3 est assurée par un transistor MOS haute tension 4 (ou par un deuxième IGBT) relié entre l'anode du thyristor 3 et sa gâchette. La source du transistor haute tension 4 est reliée à la cathode K par l'intermédiaire d'un transistor MOS M basse tension dont la grille est reliée à une deuxième borne de commande G2. La grille du transistor 4 est, de préférence reliée à la borne G1. En variante, on peut prévoir une impédance entre les grilles des transistors 2 et 4, ou des signaux de commande individualisés pour chacun des transistors 2, 4 et M.

On notera que l'interrupteur 1 de la figure 1 constitue un composant unidirectionnel et que l'on doit donc utiliser deux interrupteurs de ce type en série-opposition pour obtenir un variateur de puissance double alternance. Par exemple, la borne A d'un premier interrupteur 1 tel que représenté à la figure 1 est connectée à une première borne d'une charge à alimenter dont l'autre borne est reliée à une première borne d'application de la tension secteur. L'autre borne d'application de la tension secteur est alors reliée à la borne A d'un deuxième interrupteur 1 dont la borne K est reliée à la borne K du premier interrupteur.

Le fonctionnement du circuit de la figure 1 va être expliqué en relation avec les figures 2A à 2C qui représentent, sous forme de chronogrammes, respectivement la tension V_{g2} sur la grille G2, la tension V_{g1} sur la grille G1 et le courant I_{AK} entre l'anode A et la cathode K de l'interrupteur 1 de la figure 1. On considère une alternance positive de la tension V_{AK} entre les bornes A et K. A un instant t1, compris dans la première moitié d'une alternance de la tension du secteur en fonction de l'angle de conduction souhaité, on commande la grille G2 du transistor M pour rendre celui-ci conducteur, de sorte que la gâchette et la cathode du thyristor 3 sont court-circuitées et que ce thyristor ne peut pas entrer en conduction. A un instant t2, postérieur à l'instant tl et également choisi en fonction de l'angle de conduction désiré, on applique sur la gâchette G1 de l'IGBT 2 une rampe de tension dont la pente est contrôlée de façon à obtenir le di/dt souhaité. Cette rampe résulte par exemple de l'application d'un signal en créneau ou impulsionnel à travers une impédance fixe ou variable (de faible puissance puisqu'il s'agit d'un signal de commande), par exemple, une résistance ou un filtre RC. Dès que la tension sur la borne G1 dépasse une valeur de seuil Vₜₕ, le courant I_{AK} se mette à croître progressivement jusqu'à une valeur fonction de la tension secteur et de l'impédance de la charge à cet instant. Ensuite, à un instant t3, on coupe le signal sur la grille G2 pour bloquer le transistor M. Comme le transistor 4 a été rendu conducteur par la rampe appliquée sur la grille G1 et sur sa propre grille, le courant circulant dans le transistor 4 déclenche le thyristor 3. Ce thyristor 3 devient passant et sa conduction domine celle de l'IGBT 2 puisque, de façon générale, un thyristor présente une chute de tension plus faible qu'un transistor de puissance MOS ou IGBT. Ensuite, à un instant t4, on coupe le signal sur la grille G1, de sorte que l'IGBT 2 et le transistor 4 se bloquent définitivement. Ainsi, vers la fin de l'alternance, à un instant t5, le courant I_{AK} passe en dessous d'une valeur de seuil Iₕ et le thyristor se bloque. C'est pour éviter la remise en conduction de l'IGBT 2 que l'on a interrompu la tension de grille G1.

On notera que ce qui a été désigné comme un IGBT 2 et comme un transistor 4 peuvent indifféremment être l'un et l'autre des IGBT ou des transistors MOS ou bipolaires de puissance. D'autres circuits d'interrupteur de puissance monolithique à di/dt contrôlé du type auquel s'applique la présente invention sont décrits dans la demande de brevet français N° 98/16771 de la demanderesse dont le contenu sera considéré ici comme connu.

Comme il ressort de la description du fonctionnement de l'interrupteur de puissance de la figure 1, celui-ci doit être commandé par deux impulsions de tension à chaque alternance de la tension alternative. Une impulsion est destinée à rendre passant l'IGBT 2 tandis qu'une autre impulsion est destinée à subir une inflexion de pente contrôlée pour commander le transistor M. Ces impulsions de commande présentent plusieurs contraintes. Une première contrainte est qu'il s'agit d'impulsions de tension alors qu'il est plus fréquent, dans le domaine de la variation de puissance, de commander des composants (par exemple, des triacs) par des impulsions de courant. Une deuxième contrainte est qu'il est ici nécessaire de commander deux interrupteurs (IGBT 2 et transistor M) alors que dans des circuits classiques connus de variations de puissance à base de triac, on ne commande qu'une seule gâchette. Une troisième contrainte par rapport à des circuits utilisant des triacs est que la commande doit désormais être unidirectionnelle en tension.

Bien sûr, la solution qui vient à l'esprit pour réaliser la commande d'un tel interrupteur de puissance est d'utiliser un circuit numérique (par exemple, à base d'un microprocesseur) pour générer de façon parfaitement contrôlée les impulsions de tension souhaitées. Toutefois, une telle solution présente l'inconvénient d'être particulièrement coûteuse et de nécessiter une alimentation auxiliaire d'un composant numérique.

Un objet de la présente invention est de proposer un générateur d'impulsions de tension qui respecte les contraintes indiquées précédemment et qui pallie les inconvénients d'une solution numérique.

Un autre objet de la présente invention est de proposer un circuit de génération d'impulsions dont la majeure partie des constituants sont intégrables.

Un autre objet de la présente invention est de proposer une solution particulièrement simple et peu encombrante.

Plus généralement, l'invention vise à proposer un générateur d'impulsions de tension pour commander un interrupteur de puissance de type IGBT ou MOS.

Pour atteindre ces objets, la présente invention prévoit un générateur analogique d'impulsions de tension, comportant un premier composant à retournement de type diode Shockley pour activer un front montant d'une impulsion sur une borne de sortie ; et un deuxième composant de type thyristor pour bloquer le premier composant et désactiver l'impulsion.

Selon un mode de réalisation de la présente invention, le générateur d'impulsions comporte une cellule RC entre une borne d'entrée et ledit premier composant pour pré-régler l'instant d'apparition d'un front montant d'une impulsion.

Selon un mode de réalisation de la présente invention, le générateur d'impulsions comporte une première résistance entre ledit premier composant et ladite borne de sortie du générateur.

Selon un mode de réalisation de la présente invention, le générateur d'impulsions comporte une deuxième résistance en parallèle sur le deuxième composant.

Selon un mode de réalisation de la présente invention, le premier composant est constitué d'un premier élément de type thyristor associé à un deuxième élément de type diode Zener entre sa gâchette et son anode.

Selon un mode de réalisation de la présente invention, le deuxième composant est un thyristor à gâchette de cathode dont l'anode est connectée à la cathode du premier composant et dont la gâchette est reliée, par l'intermédiaire d'une diode Zener, à une borne d'un condensateur propre à être chargée lorsque le premier composant est passant.

Selon un mode de réalisation de la présente invention, le deuxième composant est un thyristor à gâchette d'anode propre à être relié à une entrée de détection de la mise en conduction, par le front montant d'une impulsion, d'un composant de type MOS ou IGBT.

Selon un mode de réalisation de la présente invention, une diode est intercalée entre la gâchette d'anode du deuxième composant et la borne de mesure, une diode Zener étant de préférence intercalée entre la gâchette d'anode du deuxième composant de type thyristor et la borne de mesure.

La présente invention prévoit aussi un circuit de commande d'une charge propre à être alimentée par une haute tension alternative comportant au moins un interrupteur de puissance à di/dt contrôlé comprenant le montage en parallèle d'un composant de type MOS ou IGBT et d'un composant de type thyristor, avec des moyens pour inhiber le composant de type thyristor pendant la phase de fermeture de l'interrupteur qui est assurée par le composant de type IGBT ; et au moins un générateur d'impulsions de tension du type ci-dessus pour commander de façon impulsionnelle la fermeture du composant de type IGBT.

Selon un mode de réalisation de la présente invention, le moyen pour inhiber le composant de type thyristor de l'interrupteur de puissance est constitué d'un transistor de type MOS dont la grille est également commandée de façon impulsionnelle, au moyen dudit générateur d'impulsions de tension.

Selon un mode de réalisation de la présente invention, le circuit comporte deux interrupteurs de puissance, montés en série-opposition l'un avec l'autre et en série avec la charge à commander, chaque interrupteur étant associé à un signe d'alternances de la tension alternative et étant commandé par un générateur d'impulsions, l'instant d'apparition d'un front montant d'une impulsion par rapport au début d'une alternance de la tension alternative étant réglé au moyen d'un élément résistif commun aux deux générateurs et monté en série avec deux condensateurs de stockage respectivement dédiés à l'un des générateurs.

Selon un mode de réalisation de la présente invention, le circuit comporte deux interrupteurs de puissance, montés en série-opposition l'un avec l'autre et en série avec la charge à commander, chaque interrupteur étant associé à un signe d'alternances de la tension alternative et les deux interrupteurs étant commandés par un même générateur d'impulsions associé à un moyen de redressement, l'instant d'apparition d'un front montant d'une impulsion par rapport au début d'une alternance de la tension alternative étant réglé au moyen d'un élément résistif en série avec un condensateur de stockage.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un mode de réalisation d'un interrupteur de puissance à di/dt contrôlé du type auquel s'applique préférentiellement la présente invention ;
les figures 2A, 2B et 2C illustrent, sous forme de chronogrammes, le fonctionnement d'un interrupteur de puissance tel que représenté en figure 1 ;
la figure 3 représente, de façon schématique, un premier mode de réalisation d'un générateur d'impulsions de tension selon la présente invention ;
la figure 4 représente, de façon schématique, un deuxième mode de réalisation d'un générateur d'impulsions de tension selon la présente invention ;
les figures 5A, 5B et 5C illustrent, sous forme de chronogrammes, le fonctionnement du générateur de la figure 4 ;
la figure 6 représente, de façon schématique, un premier mode de réalisation d'un circuit de commande d'une charge mettant en oeuvre l'invention ;
la figure 7 représente, de façon schématique, un deuxième mode de réalisation d'un circuit de commande d'une charge mettant en oeuvre l'invention ; et
la figure 8 représente, de façon schématique, un troisième mode de réalisation d'un circuit de commande d'une charge mettant en oeuvre l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la charge devant être commandée par l'interrupteur de puissance à di/dt contrôlé auquel s'applique l'invention n'a pas été détaillée et ne fait pas l'objet de la présente invention. On notera simplement que l'invention s'applique plus particulièrement à des applications dans lesquelles on souhaite faire varier la puissance d'alimentation de la charge.

Une caractéristique de la présente invention est de prévoir un circuit analogique pour générer des impulsions de tension au moyen, essentiellement, d'un composant à retournement de type diode Shockley et d'un composant de type thyristor. On utilise un premier composant à retournement ou équivalent pour activer l'impulsion, c'est-à-dire pour établir son front montant, et un deuxième composant de type thyristor ou équivalent pour désactiver l'impulsion, c'est-à-dire générer son front descendant en annulant le courant dans le premier composant.

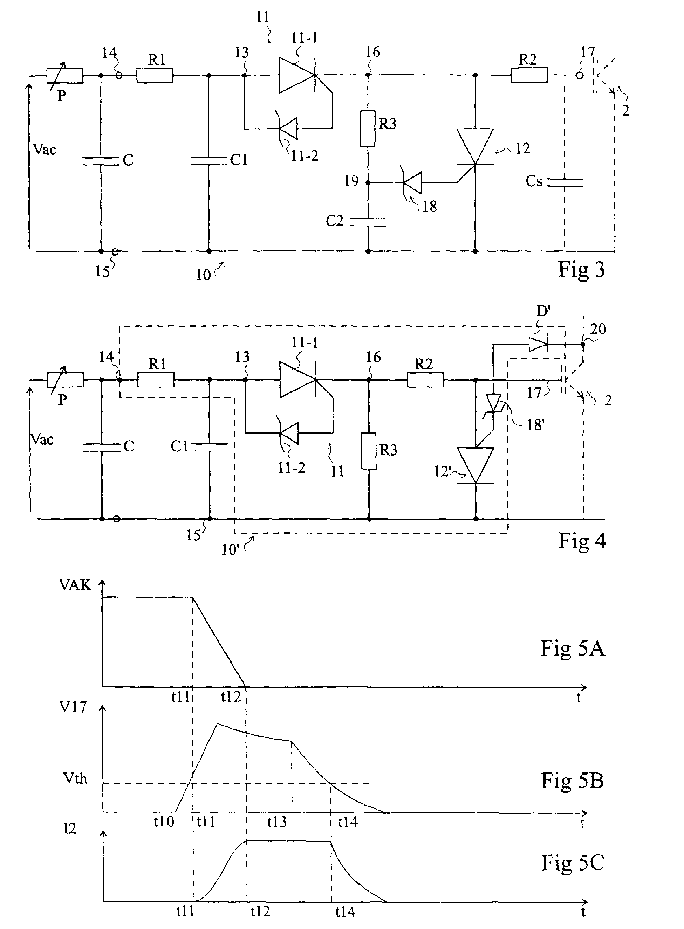

La figure 3 représente un premier mode de réalisation d'un générateur d'impulsions de tension selon la présente invention. Ce générateur 10 comporte un premier composant 11 de type diode Shockley ou équivalent dont le rôle est d'être rendu passant pour générer le front montant d'une impulsion, et un deuxième composant 12 de type thyristor ou équivalent dont le rôle est de générer le front descendant de l'impulsion.

Le composant 11 est représenté sous la forme d'un thyristor 11-1 avec une diode Zener 11-2 entre sa gâchette et son anode 13, l'anode de la diode 11-2 étant connectée à la gâchette du thyristor 11-1. Fonctionnellement, le composant 11 est rendu passant quand la tension à ses bornes dépasse un seuil (fixé par la diode Zener 11-2) et présente, une fois passant, une faible chute de tension (celle du thyristor 11-1). Ce composant se bloque par disparition du courant (courant inférieur au courant de maintien du thyristor 11-1).

L'anode 13 du thyristor 11-1 (définissant l'anode du composant 11) est reliée, par l'intermédiaire d'une résistance R1 à une première borne 14 d'entrée du générateur. La borne 14 est destinée à recevoir une tension de commande permettant de fixer les caractéristiques des impulsions. Dans le cas d'un circuit alimenté par une tension alternative (par exemple, la tension secteur), cette tension de commande règle le retard entre le front montant de l'impulsion et le début de l'alternance. La tension de commande est appliquée entre la première borne 14 et une deuxième borne d'entrée 15 constituant la référence (par exemple, la masse) du générateur. La résistance R1 est constitutive d'une cellule RC d'entrée en association avec un condensateur C1 connecté entre les bornes 13 et 15. Le composant 11 est rendu passant lorsque la tension aux bornes du condensateur Cl devient supérieure à la tension seuil de la diode Zener 11-2 en considérant que la cathode 16 du thyristor 11-1 (définissant la cathode du composant 11) est à un potentiel nul au repos (correspondant au potentiel de la référence 15). La cathode 16 du thyristor 11 est reliée, par l'intermédiaire d'une résistance R2, à une borne 17 de sortie du générateur, destinée à être connectée à la grille du composant de type IGBT ou MOS à commander (IGBT 2 représenté en pointillés à la figure 3). Le thyristor 12 ou équivalent, destiné à désactiver l'impulsion, a sa cathode connectée à la borne de référence 15.

Dans le mode de réalisation de la figure 3, le thyristor 12 est un thyristor à gâchette de cathode et a son anode connectée à la cathode 16 du thyristor 11-1. La gâchette du thyristor 12 est reliée, par une diode Zener 18, au point milieu 19 d'une association en série d'une résistance R3 avec un condensateur C2 reliée entre les bornes 16 et 15. L'anode de la diode Zener 18 est connectée à la gâchette du thyristor 12 tandis que sa cathode est connectée au point 19. La résistance R3 sert à réaliser un retard entre les instants de charge et de décharge de la grille du composant à commander. Le cas échéant, un condensateur Cs peut être prévu entre les bornes 17 et 15. Ce condensateur participe alors au réglage des constantes de temps comme on le verra par la suite et à pour avantage, notamment, de supprimer les effets d'éventuelles dispersions technologiques dans la fabrication de l'IGBT. Pour souligner son caractère optionnel, ce condensateur Cs qui peut toutefois être réalisé sous forme intégré avec le circuit 10 a été, en figure 3, connecté par des liaisons en pointillés.

Le rôle de la diode Zener 18 est de rendre conducteur le thyristor 12 quand la tension accumulée par le condensateur C2 devient supérieure à la tension seuil de la diode 18. Cette accumulation de tension aux bornes du condensateur C2 intervient pendant que l'impulsion est active, c'est-à-dire quand le thyristor 11-1 est passant. La mise en conduction du thyristor 12 court-circuite les bornes 16 et 15, ce qui a plusieurs conséquences. Tout d'abord, cela décharge la grille du composant 2 connectée à la borne 17 et, s'il est présent, le condensateur Cs, ce qui désactive l'impulsion. De plus, cela provoque la décharge du condensateur C2 de façon à remettre le circuit dans une position de repos où ce condensateur C2 est déchargé pour une impulsion ultérieure. En outre, le thyristor 12 à l'état passant sert à décharger le condensateur d'entrée C1 par le thyristor 11-1 qui ne se bloque que lorsque le courant qui le traverse s'annule (plus précisément, devient inférieur à son courant de maintien), c'est-à-dire lorsque le condensateur C1 est en grande partie déchargé. Une fois le thyristor 11-1 bloqué, le thyristor 12 se bloque également dans la mesure où il n'est plus traversé que par un courant inférieur à son courant de maintien. Par souci de simplification, on fera parfois référence à une absence de courant alors qu'il s'agit en fait de courants inférieurs aux courants de maintien des thyristors 11-1 et 12.

La durée de l'impulsion de tension dépend du dimensionnement de la résistance R3, du condensateur C2 et de la diode Zener 18. De plus, en considérant uniquement les constituants du générateur 10, le retard à l'amorçage du thyristor 11-1 par rapport au début d'un cycle de charge du condensateur C1 dépend de la valeur de la diode Zener 11-2 ainsi que la constante de temps de la cellule R1-C1 qui peut être considérée comme un élément de pré-réglage. En pratique, d'autres composants externes au générateur 10 influeront le plus souvent sur ce retard, comme on le verra ci-après.

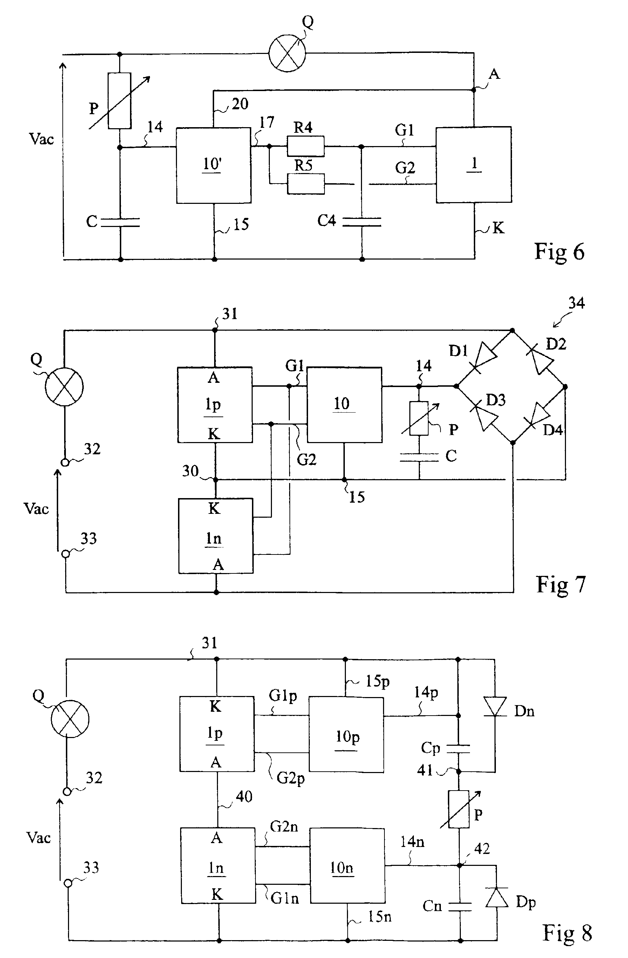

Dans l'exemple représenté à la figure 3, on considère que le générateur d'impulsions 10 est destiné à être alimenté par une tension alternative Vac, par exemple la tension secteur. Dans un tel cas, pour constituer un variateur de puissance, on connecte un potentiomètre P entre une première borne d'application de la tension Vac et la borne 14, et on connecte un condensateur C entre les bornes 14 et 15, la borne 15 constituant la seconde borne d'application de la tension Vac. Au moyen d'une telle connexion, l'instant d'amorçage du thyristor 11-1, c'est-à-dire le début d'une impulsion de tension par rapport au passage à zéro de la tension alternative Vac est réglé par les dimensionnements des condensateurs C et Cl et de la résistance R1, ainsi que par la résistance réglée du potentiomètre P. On verra en relation avec la figure 6 que la charge peut, dans certains cas, intervenir sur le réglage de l'instant d'amorçage.

On notera qu'un générateur d'impulsions 10 illustré par la figure 3 ne fonctionne que pour un signe des alternances de la tension alternative Vac. En effet, le composant 11 est un composant unidirectionnel en tension. Ceci n'est toutefois pas gênant dans la mesure où le composant 2 de type IGBT ou transistor MOS que doit commander le générateur d'impulsions est lui-même un composant de type unidirectionnel et qu'il est nécessaire de prévoir deux circuits du type de celui représenté à la figure 1 pour obtenir un variateur de puissance fonctionnant avec les alternances positives et négatives de la tension d'alimentation alternative. Par conséquent, on prévoira également deux générateurs d'impulsions 10 selon l'invention. Aucune modification structurelle n'est nécessaire pour que le circuit fonctionne avec des alternances négatives, il suffit d'inverser les bornes de connexion de la tension d'alimentation.

La figure 4 représente un deuxième mode de réalisation d'un générateur d'impulsions de tension 10' selon l'invention. Le générateur 10' reprend les composants du générateur de la figure 3 pour ce qui concerne l'activation de l'impulsion, c'est-à-dire les connexions du composant 11 (thyristor 11-1 et diode Zener 11-2), de la résistance R1 et du condensateur C1. De même, la cathode 16 du composant 11 est connectée, par l'intermédiaire de la résistance R2, à la grille 17 du composant 2 à commander. Le condensateur Cs n'a pas été représenté en figure 4. Il peut cependant être présent pour les mêmes raisons que celles exposées en relation avec la figure 3.

Selon le mode de réalisation de la figure 4, le composant de type thyristor, destiné à éteindre l'impulsion, est un thyristor 12' à gâchette d'anode connecté entre la borne 17 et la borne 15, l'anode du thyristor 12' étant reliée à la borne 17. Le thyristor 12' a, comme précédemment, pour rôle de ramener la grille du composant 2 à la masse et de décharger les condensateurs C1, C et éventuellement Cs, afin de provoquer le blocage du thyristor 11-1. Selon ce mode de réalisation, la gâchette d'anode du thyristor 12' est connectée, par l'intermédiaire d'une diode D', à une borne 20 d'entrée de mesure du générateur, destinée à être connectée à l'anode de l'IGBT 2. L'anode de la diode D' est connectée à la gâchette du thyristor 12'. De façon optionnelle, une diode Zener 18' relie la gâchette du thyristor 12' à l'anode de la diode D'. Le rôle de la diode 18' est de régler la chute de tension aux bornes de l'IGBT 2 à partir de laquelle on décide de décharger sa grille 17. Une résistance R3 reste prévue entre les bornes 16 et 15 pour assurer une décharge permanente des condensateurs C1 et Cs après la commande.

Le fonctionnement du circuit de la figure 4 est similaire à celui exposé en relation avec la figure 3 à la différence près que la durée de l'impulsion n'est plus réglée par un condensateur interne au générateur d'impulsions mais, de façon externe, par une mesure de la tension aux bornes du composant que l'on commande. Ainsi, l'ordre d'ouverture de l'IGBT 2 est généré par la fin de l'amorçage de l'IGBT lui-même. Il n'y a donc plus besoin de pré-programmer le générateur d'impulsions pour fixer la fin de l'impulsion au moyen d'un retard réalisé par la charge du condensateur C2 (figure 2). Quand l'IGBT 2 se bloque, un courant circule dans la gâchette d'anode du thyristor 12', ce qui a pour effet de l'amorcer. On notera que si la diode Zener 18' est prévue, celle-ci retarde l'instant d'amorçage du thyristor 12' par rapport à la disparition du courant dans l'IGBT 2. Le rôle de la diode D' est de protéger la gâchette du thyristor 12' en empêchant au courant d'anode de l'interrupteur 1 (figure 1) commandé de venir détruire le thyristor 12'.

Un avantage du mode de réalisation de la figure 4, par rapport à celui de la figure 3 est que, à l'exception du condensateur C1, tous les constituants du générateur d'impulsions de tension 10' sont intégrables alors que le condensateur C2 de la figure 3 n'est pas facilement intégrable sur silicium.

On notera que, dans le mode de réalisation de la figure 3, on veillera pour la durée de l'impulsion à faire en sorte que le front descendant soit présent en fin d'amorçage de l'IGBT 2. Dans le mode de réalisation de la figure 4, cette adaptation s'effectue de façon automatique.

Les figures 5A, 5B et 5C illustrent le fonctionnement du générateur d'impulsions de tension 10' de la figure 4 en représentant, sous forme de chronogrammes, un exemple d'allures de la tension V_{AK} aux bornes du composant 2 à commander, de la tension de grille V17 du composant 2 et du courant I2 le traversant. On suppose qu'à un instant t10 la tension aux bornes du condensateur C1 dépasse le seuil de la diode Zener 11-2. Il en découle une mise en conduction du thyristor 11-1 ce qui provoque un front montant de l'impulsion de tension sur la grille 17 du composant 2. Sous l'effet de l'application d'une tension de grille, le composant de type IGBT 2 à commander devient conducteur juste après (instant t11) que sa tension de grille ait dépassé son seuil de conduction Vₜₕ. La tension V_{AK} se met à diminuer tandis que le courant I2 traversant ce composant augmente jusqu'à atteindre un niveau nominal à un instant t12. L'allure de la tension V17 est pendant ce temps légèrement décroissante par la décharge du condensateur C1 dans la résistance R3. A l'instant t12 où le composant 2 est entièrement passant, un courant se met à circuler depuis la gâchette d'anode du thyristor 12' ce qui rend ce dernier conducteur. Dans l'exemple des figures 5A à 5C, on a illustré un léger retard, c'est-à-dire qu'on a considéré une mise en conduction du thyristor 12' à un instant t13 légèrement postérieur à l'instant t12 pour tenir compte de la présence de la diode Zener 18'. A partir de l'instant t13, le thyristor 12' devenant conducteur, celui-ci décharge la grille 17 du composant 2 (figure 5B) ainsi que la capacité C1 d'entrée du générateur d'impulsions. On notera que, dans l'exemple des figures 5A et 5C, on considère que le courant I2 disparaît par le blocage du composant de type IGBT alors que la tension V_{AK} reste nulle dans la mesure où on considère l'exemple du circuit de la figure 1 dans lequel le thyristor 3 est devenu passant. Le courant I2 commence à décroître à un instant t14 où la tension V17 est redescendue en dessous du seuil Vₜₕ.

La figure 6 représente, de façon schématique, un premier exemple d'application d'un générateur de tension 10' de l'invention à la commande d'un interrupteur de puissance à di/dt contrôlé du type de celui illustré en figure 1. Dans l'exemple de la figure 6, on suppose que la charge Q (par exemple, une lampe) dont on souhaite faire varier la puissance au moyen du potentiomètre P n'est alimentée que par une alternance sur deux de la tension alternative Vac. A titre de variante, on peut considérer la présence d'un pont de redressement en amont du potentiomètre P et que la tension appliquée aux bornes de l'association en série du potentiomètre P et du condensateur C est une tension redressée auquel cas la lampe Q est alimentée en double alternance.

Pour assurer la commande d'un interrupteur de puissance 1 à di/dt contrôlé et, plus particulièrement, pour fixer la pente de commande de la grille Gl de l'IGBT 2, (figure 1), on prévoit une cellule RC entre la borne 17 de sortie du générateur 10' et la borne Gl. Par conséquent, comme l'illustre la figure 6, une résistance R4 relie la borne 17 à la grille Gl qui est elle-même reliée à la masse (borne 15 du générateur 10' ou cathode K de l'interrupteur 1) par l'intermédiaire d'un condensateur C4. La grille G2 du transistor MOS M est quand à elle reliée à la borne de sortie 17 par l'intermédiaire d'une résistance R5. En effet, on n'a ici pas besoin d'infléchir la pente du front montant de l'impulsion de commande (instant t1, figure 2A). En utilisant un seul générateur d'impulsions de tension, la cellule R4-C4 sert non seulement à infléchir la pente du front montant de l'impulsion en commande de la grille G1 mais également à apporter le retard nécessaire entre les signaux V_{g1} et V_{g2} (figures 2B et 2A). Le fait que le front descendant de l'impulsion intervient simultanément sur la borne 17 pour les deux grilles n'est pas gênant en raison de la décharge du condensateur C4 qui retarde alors l'instant (t4, figure 2B) de disparition de l'impulsion sur la grille G1 par rapport à l'instant (t3, figure 2A) de disparition de l'impulsion sur la grille G2. On voit donc que le générateur de l'invention est parfaitement compatible avec l'utilisation d'un interrupteur de puissance à di/dt contrôlé tel qu'illustré par la figure 1.

A titre de variante non représentée du montage de la figure 6, le potentiomètre P est connecté entre les bornes 14 et A. Dans ce cas, la charge Q intervient dans les durées caractéristiques de fonctionnement du montage et en particulier, sur le retard à l'amorçage du thyristor 11-1 (figure 3) par rapport au début des alternances positives.

Comme cela a déjà été indiqué précédemment, on aura recours à deux interrupteurs de puissance tels qu'illustrés par la figure 1 pour faire fonctionner une charge à la fois sur les alternances positives et négatives d'une alimentation alternative. Selon que ces interrupteurs sont associés en série dans un montage à cathodes communes ou à anodes communes, on utilisera un seul générateur d'impulsions de tension associé à un pont redresseur dans le cas d'un montage à cathodes communes ou deux générateurs d'impulsions de tension distincts, dans le cas d'un montage à anodes communes. Les figures 7 et 8 illustrent ces deux exemples d'application de l'invention.

La figure 7 représente un deuxième mode de réalisation d'un circuit de commande d'une charge Q au moyen de deux interrupteurs lp et 1n respectivement associés aux alternances positives et négatives d'une tension alternative Vac (par exemple, la tension secteur). A la figure 7, les interrupteurs lp et 1n sont montés en cathodes communes, c'est-à-dire que les cathodes respectives K des deux triacs (3, figure 1) des interrupteurs lp et 1n sont connectées ensemble (noeud 30, figure 7). L'anode A d'un premier interrupteur (par exemple 1p) est connectée à une première borne 31 de la charge Q dont l'autre borne 32 est reliée à une première borne d'application (par exemple, la borne de phase) de la tension Vac. L'autre borne 33 (par exemple le neutre) d'application de la tension Vac est reliée à l'anode A du deuxième interrupteur 1n. La commande des interrupteurs lp et 1n est effectuée au moyen d'un seul générateur d'impulsions 10 conforme à l'invention. Les bornes 14 et 15 de ce générateur 10 reçoivent une tension redressée au moyen, par exemple, d'un pont 34 de diodes D1, D2, D3 et D4. Les bornes d'entrée alternative du pont 34 (anode de la diode D1 commune à la cathode de la diode D2 - anode de la diode D3 commune à la cathode de la diode D4) sont respectivement reliées aux bornes 31 et 33 tandis que ses bornes de sortie redressée (cathodes des diodes D1, D3 et anodes des diodes D2, D4) sont reliées aux bornes 14 et 15, la référence de tension (borne 15) étant en outre reliée au noeud 30. Le générateur 10 délivre, soit directement, soit par l'intermédiaire d'un montage résistif et capacitif (non représenté et supposé contenu dans le bloc 10 de la figure 7) similaire à celui de la figure 6, les signaux de commande des grilles G1 et G2 des interrupteurs 1p et 1n. Dans ce mode de réalisation, ces grilles sont communes aux deux interrupteurs, c'est-à-dire qu'un même signal est envoyé sur les grilles G1 des deux interrupteurs 1p et 1n, et qu'un même signal est envoyé sur les grilles G2 des deux interrupteurs 1p et 1n. La variation de puissance est ici commandée par un potentiomètre P, monté en série avec un condensateur C, entre les bornes 14 et 15.

La figure 8 représente un troisième mode de réalisation d'un circuit de commande d'une charge Q au moyen de deux interrupteurs 1p et 1n respectivement associés aux alternances positives et négatives d'une tension alternative Vac (par exemple, la tension secteur) . A la figure 8, les interrupteurs lp et 1n sont montés en anodes communes, c'est-à-dire que les anodes respectives A des deux triacs (3, figure 1) des interrupteurs 1p et 1n sont connectées ensemble (noeud 40, figure 8). La cathode K d'un premier interrupteur (par exemple 1p) est connectée à une première borne 31 de la charge Q dont l'autre borne 32 est reliée à une première borne d'application (par exemple, la borne de phase) de la tension Vac. L'autre borne 33 (par exemple le neutre) d'application de la tension Vac est reliée à la cathode K du deuxième interrupteur 1n. La commande des interrupteurs 1p et 1n est effectuée au moyen de deux générateurs d'impulsions 10p et 10n dédiés, chacun à l'un des interrupteurs. Le générateur 10p délivre donc les signaux de commande aux grilles G1p et G2p de l'interrupteur 1p tandis que le générateur 10n délivre les signaux de commande aux grilles Gln et G2n de l'interrupteur 1n. Les références de tension respectives (bornes 15p et 15n) des générateurs 10p et 10n sont séparées et reliées, respectivement, aux bornes 31 et 33. Toutefois, selon l'invention, on utilise un élément de commande (potentiomètre P) commun pour régler la puissance d'alimentation de la charge Q. Pour cela, un premier condensateur Cp est connecté entre la borne 31 et une première borne 41 du potentiomètre P. Ce condensateur Cp est destiné au générateur 10p dont la borne 14p est reliée à la borne 31. Un deuxième condensateur Cn, destiné au générateur 10n, est connecté entre la deuxième borne 42 du potentiomètre P et la borne 33. La borne 14n du générateur 10n est alors reliée à cette borne 42. Pour dédier chaque condensateur à l'un des générateurs, deux diodes Dp et Dn sont respectivement montées en parallèle sur ces condensateurs Cp et Cn, l'anode de la diode Dn étant reliée à la borne 31 et l'anode de la diode Dp étant reliée à la borne 33.

Le fonctionnement des montages des figures 7 et 8 se déduit de l'exposé ci-dessus des figures précédentes. On notera cependant que le montage de la figure 7 constitue un mode de réalisation préféré, notamment, car il ne nécessite qu'un condensateur C et qu'un générateur 10.

Dans l'exemple des figures 7 et 8, on a considéré le recours à des interrupteurs 10 du mode de réalisation de la figure 3, c'est-à-dire sans asservissement. On pourra toutefois avoir recours à des générateurs 10' (figure 4) en connectant, dans le montage de la figure 8, la borne 20 des deux générateurs à l'anode commune des interrupteurs 1p et 1n, et dans le montage de la figure 7, la borne 20 du générateur commun à chacune des anodes des interrupteurs 1p et 1n par l'intermédiaire de diodes pour éviter un court-circuit entre les deux anodes.

Bien entendu, la présente invention est susceptible de diverses variantes et modifications qui apparaîtront à l'homme de l'art. En particulier, les dimensionnements des différents composants du générateur d'impulsions de tension de l'invention sont à adapter en fonction de l'application et, notamment, en fonction des retards à l'amorçage souhaités et des durées d'impulsions souhaitées. De plus, bien que l'invention ait été plus particulièrement décrite en relation avec une application préférée à un interrupteur de puissance à di/dt contrôlé, on notera que le générateur d'impulsions de tension de l'invention peut trouver d'autres applications. Par exemple, un tel générateur peut servir à commander un transistor MOS aux bornes duquel on souhaite récupérer un signal oscillant. Dans ce cas, le générateur de tension de l'invention peut même être alimenté par une source de tension continue en étant associé à un potentiomètre (P) et à un condensateur (C) tels qu'illustrés par les figures 3 et 4. Le potentiomètre règle alors la fréquence et le rapport cyclique. Le temps de montée du signal oscillant est fixé par le potentiomètre P qui conditionne le temps de charge du condensateur C. Le temps de descente du signal oscillant est fixé au premier ordre, par les résistances R1 et R2, et au deuxième ordre, par le potentiomètre P et la charge. L'adaptation d'un générateur d'impulsions de tension de l'invention à une telle application est à la portée de l'homme du métier à partir des indications fonctionnelles données ci-dessus. En outre, on notera que si le recours à un composant de type diode Shockley et à un thyristor à gâchette d'anode constitue un mode de réalisation préféré, d'autres composants à fonction équivalente pourront être utilisés.

## Revendications

1. Générateur analogique d'impulsions de tension, caractérisé en ce qu'il comporte :
un premier composant (11) à retournement de type diode Shockley pour activer un front montant d'une impulsion sur une borne de sortie (17) ;et
un deuxième composant (12, 12') de type thyristor pour désactiver l'impulsion à l'issue d'un délai prédéterminé qui suit l'activation de l'impulsion.

2. Générateur d'impulsions selon la revendication 1, caractérisé en ce qu'il comporte une cellule RC (R1, C1) entre une borne d'entrée (14) et ledit premier composant (11) pour pré-régler l'instant d'apparition d'un front montant d'une impulsion.

3. Générateur d'impulsions selon la revendication 1 ou 2, caractérisé en ce qu'il comporte une première résistance (R2) entre ledit premier composant (11) et ladite borne de sortie du générateur (17).

4. Générateur selon l'une quelconque des revendications 1 à 3, caractérisé en ce qu'il comporte une deuxième résistance (R3) en parallèle sur le deuxième composant (12).

5. Générateur selon l'une quelconque des revendications 1 à 4, caractérisé en ce que ledit premier composant (11) est constitué d'un premier élément de type thyristor (11-1) associé à un deuxième élément de type diode Zener (11-2) entre sa gâchette et son anode.

6. Générateur d'impulsions selon l'une quelconque des revendications 1 à 5, caractérisé en ce que ledit deuxième composant est un thyristor à gâchette de cathode (12) dont l'anode est connectée à la cathode du premier composant (11) et dont la gâchette est reliée, par l'intermédiaire d'une diode Zener (18), à une borne d'un condensateur (C2) propre à être chargée lorsque le premier composant est passant.

7. Générateur d'impulsions selon l'une quelconque des revendications 1 à 5, caractérisé en ce que ledit deuxième composant est un thyristor à gâchette d'anode (12') propre à être relié à une entrée (20) de détection de la mise en conduction, par le front montant d'une impulsion, d'un composant (2) de type MOS ou IGBT.

8. Générateur d'impulsions selon la revendication 7, caractérisé en ce qu'une diode (D') est intercalée entre la gâchette d'anode du deuxième composant (12') et la borne (20) de mesure, une diode Zener (18') étant de préférence intercalée entre la gâchette d'anode du deuxième composant de type thyristor (12') et la borne de mesure (20).

9. Circuit de commande d'une charge (Q) propre à être alimentée par une haute tension alternative (Vac), caractérisé en ce qu'il comporte :
au moins un interrupteur de puissance (1, 1p, 1n) à di/dt contrôlé comprenant le montage en parallèle d'un composant de type MOS ou IGBT (2) et d'un composant de type thyristor (3), avec des moyens pour inhiber le composant de type thyristor pendant la phase de fermeture de l'interrupteur qui est assurée par le composant de type IGBT ; et
au moins un générateur (10, 10', 10p, 10n) d'impulsions de tension selon l'une quelconque des revendications 1 à 8, pour commander de façon impulsionnelle la fermeture du composant de type IGBT (2).

10. Circuit selon la revendication 9, caractérisé en ce que ledit moyen pour inhiber le composant de type thyristor (3) de l'interrupteur de puissance (1, 1p, 1n) est constitué d'un transistor de type MOS (M) dont la grille est également commandée de façon impulsionnelle, au moyen dudit générateur (10, 10', 10p, 10n) d'impulsions de tension.

11. Circuit selon la revendication 10, caractérisé en ce qu'il comporte deux interrupteurs de puissance (1p, 1n), montés en série-opposition l'un avec l'autre et en série avec la charge (Q) à commander, chaque interrupteur étant associé à un signe d'alternances de la tension alternative (Vac) et étant commandé par un générateur d'impulsions (10p, 10n), l'instant d'apparition d'un front montant d'une impulsion par rapport au début d'une alternance de la tension alternative étant réglé au moyen d'un élément résistif (P) commun aux deux générateurs et monté en série avec deux condensateurs (Cp, Cn) de stockage respectivement dédiés à l'un des générateurs.

12. Circuit selon la revendication 10, caractérisé en ce qu'il comporte deux interrupteurs de puissance (1p, 1n), montés en série-opposition l'un avec l'autre et en série avec la charge (Q) à commander, chaque interrupteur étant associé à un signe d'alternances de la tension alternative (Vac) et les deux interrupteurs étant commandés par un même générateur d'impulsions (10) associé à un moyen de redressement (34), l'instant d'apparition d'un front montant d'une impulsion par rapport au début d'une alternance de la tension alternative étant réglé au moyen d'un élément résistif (P) en série avec un condensateur de stockage (C).
